(19) Europäisches Patentamt
European Patent Office
Office européen des brevets

(11) **EP 2 852 047 A1**

(12) **EUROPEAN PATENT APPLICATION**
published in accordance with Art. 153(4) EPC

(43) Date of publication:
**25.03.2015 Bulletin 2015/13**

(51) Int Cl.:
**H02P 21/14** *(2006.01)*

(21) Application number: **12883018.9**

(22) Date of filing: **15.08.2012**

(86) International application number:
**PCT/CN2012/080149**

(87) International publication number:
**WO 2014/026331 (20.02.2014 Gazette 2014/08)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Shenzhen INVT Electric Co., Ltd.
Shenzhen, Guangdong 518055 (CN)**

(72) Inventors:
• **ZHANG, Donghua**
  **Shenzhen, Guangdong 518055 (CN)**
• **XU, Tiezhu**
  **Shenzhen, Guangdong 518055 (CN)**

(74) Representative: **Kolster Oy Ab
Iso Roobertinkatu 23
PO Box 148
00121 Helsinki (FI)**

(54) **PHASE CURRENT RECONSTRUCTION METHOD AND APPARATUS**

(57) A phase current reconstruction method and apparatus. In this method, PWM phase shift is performed firstly, and when a modulation vector is in an observable region, phase difference compensation is performed on a second sampling value in a PWM carrier cycle, thereby obtaining three-phase current of a motor, reducing an error caused by phase difference of sampling points, and improving accuracy of phase current reconstruction. Further, a power factor angle of the motor and an amplitude value of a current vector are calculated by using the obtained three-phase current, and when the modulation vector is in an unobservable region, initial three-phase current of the motor is obtained according to a voltage space vector angle, the power factor angle, and the amplitude value of the current vector, and the initial three-phase current is modified through one-phase current measured in the unobservable region, thereby effectively obtaining the phase current of the motor, solving the problem that single current sampling is limited in a high modulation region, and enabling the single current sampling to be better applied in an alternating current motor speed adjustment system.

Fig. 6

**Description**

**Field of the Technology**

The present application relates to the field of motor control technology, particularly to a phase current reconstruction method and a phase current reconstruction apparatus.

**Background**

In a high-performance frequency conversion control system, a key point is to detect a phase current of a motor, which directly affects a performance of the whole control system. In a civilian product configured to regulate a speed by a frequency converter, the civilian product is susceptible to a cost, and a current sampling component is a heavy burden on a system cost. A current sampling method commonly used at present, i.e., a single current sampling method, includes: detecting and obtaining the phase current of the motor by sampling a direct current bus current.

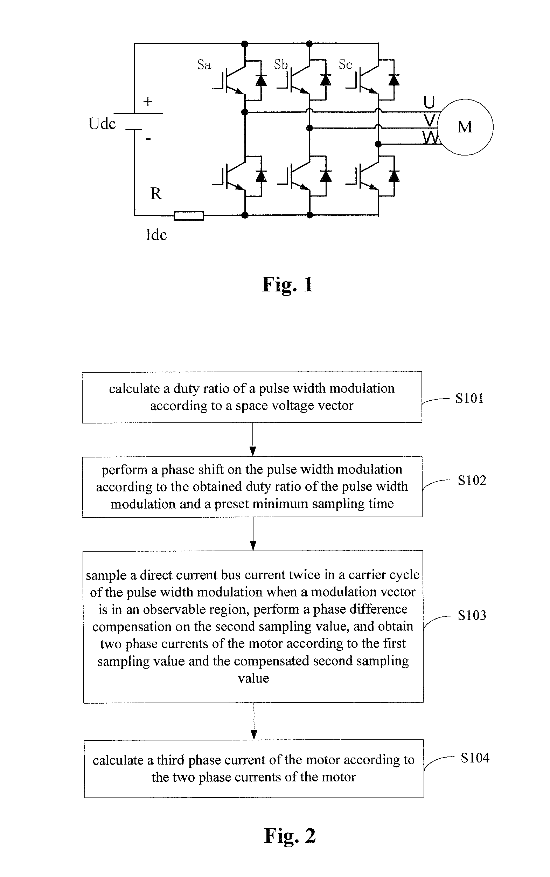

A basic principle of the method includes: performing a phase current reconstruction by utilizing phase current information presented by the direct current bus current in an operation period of an effective vector. A relationship between the direct current bus current and a motor current is determined by a switching state of an inverter. The inverter generates a Pulse Width Modulation (PWM) signal, selectively switches on or off each of multiple switching elements by the generated PWM signal, and converts a bus direct current power into an alternating current (AC) power. The converted alternating current power is provided to the motor, so as to drive the motor. A structure of a three-phase inverter is shown in Fig. 1. Switching states of switches at an upper leg of the three-phase inverter are defined as Sa, Sb and Sc, respectively. The switching state is defined as "1" when the switch tube is on, and the switching state is defined as "0" when the switch tube is off. Thus, 8 basic space vectors are formed, where 6 nonzero basic space vectors are U1(001), U2(110), U3(010), U4(011), U5(001), and U6(101), and 2 zero vectors are U0(000) and U7(111). The relationship between the direct current bus current and the phase current is shown in table 1.

Table 1: a relationship between a direct current bus current and a phase current

| vector | U0 | U1 | U2 | U3 | U4 | U5 | U6 | U7 |
|---|---|---|---|---|---|---|---|---|
| Idc | 0 | Iw | Iv | -Iu | Iu | -Iv | -Iw | 0 |

In each PWM carrier cycle, two adjacent vectors among the nonzero basic space vectors and the zero vectors operates by turns. Two phase currents can be obtained by sampling the bus current during the operation of the two nonzero basic space vectors, and a third phase current can be calculated from Iu + Iv+ Iw=0.

In a research and practice of the method, the applicant found that two phase currents are obtained separately by sampling the bus current during the operation of two different nonzero basic space vectors in one PWM carrier cycle. However, the two phase currents are not obtained at a same moment. Therefore, the condition that Iu+Iv+Iw=0 can not be satisfied in fact. Thus, a reconstructed phase current of a motor is not accurate, which has a large error.

**Summary**

In view of this, a phase current reconstruction method and a phase current reconstruction apparatus are provided in embodiments of the application, to reduce an error of a single current sampling and improve a performance of the single current sampling.

A phase current reconstruction method provided in an embodiment of the application, applicable to a motor driven in a space vector pulse width modulation mode, includes:

calculating a duty ratio of a pulse width modulation according to a space voltage vector of the motor;

performing a phase shift on the pulse width modulation according to the obtained duty ratio of the pulse width modulation and a preset minimum sampling time;

sampling a direct current bus current twice in a carrier cycle of the pulse width modulation when a modulation vector is in an observable region, performing a phase difference compensation on the second sampling value of the direct current bus current, and obtaining two phase currents of the motor according to the first sampling value of the direct current bus current and the compensated second sampling value of the direct current bus current; and

calculating a third phase current of the motor according to the two phase currents of the motor.

Preferably, the calculating a duty ratio of a pulse width modulation according to a space voltage vector of the motor includes: calculating an angle and an amplitude of the space voltage vector according to the space voltage vector of the motor; and calculating the duty ratio of the pulse width modulation according to the obtained angle and amplitude of the space voltage vector.

Preferably, the phase current reconstruction method further includes:

calculating a power factor angle of the motor and an amplitude of a current vector according to three-phase currents of the motor obtained when the modulation vector is in the observable region;

obtaining one phase current of the motor according to a sector number of the modulation vector and the sampling of the direct current bus current when the modulation vector is in a non-observable region;

calculating an angle of the current vector according to the angle of the space voltage vector and the power factor angle, calculating the current vector according to the obtained angle of the current vector and the amplitude of the current vector, and converting the current vector to obtain initial three-phase currents of the motor; and

correcting the amplitude of the current vector according to a difference between the one phase current of the motor obtained when the modulation vector is in the non-observable region and a corresponding phase current among the initial three-phase currents, calculating a corrected current vector according to the corrected amplitude of the current vector and the current vector angle, and converting the corrected current vector to obtain corrected three-phase currents of the motor.

Preferably, the calculating a power factor angle of the motor and an amplitude of a current vector according to the three-phase current of the motor obtained when the modulation vector is in the observable region includes: performing coordinate transformation based on an oriented space voltage vector of the motor on the obtained three-phase currents of the motor, to obtain active components and reactive components of the three-phase current; filtering out higher harmonics of the active components and the reactive components; and calculating the power factor angle of the motor and the amplitude of the current vector according to the active components and the reactive components of the three-phase currents after filtering out the higher harmonics.

Preferably, the sampling a direct current bus current twice in a carrier cycle of the pulse width modulation and performing a phase difference compensation on the second sampling value of the direct current bus current includes: calculating a sampling time difference $\Delta T$ between two sampling moments when the direct current bus current is sampled twice in a present carrier cycle of the pulse width modulation; obtaining a second sampling moment T1 when the direct current bus current is sampled at the second time in the present carrier cycle of the pulse width modulation, and a sampling value Idc1 obtained at the second sampling moment T1; obtaining a second sample moment T2 when the direct current bus current is sampled at the second time in a previous carrier cycle of the pulse width modulation before the present carrier cycle of the pulse width modulation, and a sampling value Idc2 obtained at the second sampling moment T2; and performing the phase difference compensation on the second sampling value Idc1 of the direct current bus current in the present carrier cycle of the pulse width modulation, where the compensation value = (Idc1 - Idc2) * $\Delta T$/(T1 - T2).

A phase current reconstruction apparatus is provided in an embodiment of the application, which establishes a communication connection with a motor driven in a space vector pulse width modulation mode, includes: a space vector pulse width modulation module, a pulse width modulation phase shift operation module, a direct current bus current sampling module, an alternating current reconstruction module and an inverter module, where

the space vector pulse width modulation module is configured to calculate a duty ratio of a pulse width modulation according to a space voltage vector of the motor, and transmit the duty ratio of the pulse width modulation to the pulse width modulation phase shift operation module;

the pulse width modulation phase shift operation module is configured to perform a phase shift on the pulse width modulation according to the obtained duty ratio of the pulse width modulation and a preset minimum sampling time, generate a first control signal to control switches of the inverter module to be on or off and generate a second control signal to control the direct current bus current sampling module to sample the direct current bus current, and transmit a first reconstruction signal to the alternating current reconstruction module when a modulation vector is in an observable region;

the inverter module is configured to switch on or off the switches according to the received first control signal, and convert a bus direct current voltage into an alternating current voltage to drive the motor;

the direct current bus current sampling module is configured to sample the direct current bus current according to the received second control signal, and transmit a sampling value of the direct current bus current to the alternating current reconstruction module; and

the alternating current reconstruction module is configured to receive two sampling values of the direct current bus current from the direct current bus current sampling module in a carrier cycle of the pulse width modulation, when the first reconstruction signal is received; perform a phase difference compensation on the second sampling value of the direct current bus current; obtain two phase currents of the motor according to the first sampling value of the direct current bus current and the compensated second sampling value of the direct current bus current; and calculate a third phase current of the motor according to the obtained two phase currents of the motor.

Preferably, the space vector pulse width modulation module calculates an angle and an amplitude of the space voltage vector according to the space voltage vector of the motor, and calculates the duty ratio of the pulse width modulation according to the obtained angle and amplitude of the space voltage vector.

Preferably, the alternating current reconstruction module further includes: a calculation unit configured to calculate a power factor angle of the motor and an amplitude of a current vector according to the three-phase currents of the motor obtained when the first reconstruction signal is received. The space vector pulse width modulation module is further configured to detect a sector number of the modulation vector, and transmit the sector number to the alternating current reconstruction module. The pulse width modulation phase shift operation module is further configured to transmit a second reconstruction signal to the alternating current reconstruction module when the modulation vector is in a non-observable region. The alternating current reconstruction module is further configured to calculate an angle of the current vector according to the angle of the space voltage vector and the power factor angle, calculate the current vector according to the angle and the amplitude of the current vector, when the second reconstruction signal is received; and convert the current vector to obtain initial three-phase currents of the motor. The alternating current reconstruction module is further configured to obtain one phase current of the motor from the direct current bus current sampling module according to the received sector number, when the second reconstruction signal is received; correct the amplitude of the current vector according to a difference between the one phase current of the motor and a corresponding phase current among the initial three-phase currents, calculate a corrected current vector according to the corrected amplitude of the current vector and the angle of the current vector, and convert the corrected current vector to obtain corrected three-phase currents of the motor.

Preferably, the calculation unit performs coordinate transformation based on an oriented space voltage vector of the motor on the obtained three-phase current of the motor, to obtain active components and reactive components of the three-phase currents; filters out higher harmonics of the active components and the reactive components; and calculates the power factor angle of the motor and the amplitude of the current vector according to the active component and the reactive component of the three-phase current after filtering out the higher harmonics.

Preferably, the alternating current reconstruction module calculates a sampling time difference $\Delta T$ between two sampling moments when the direct current bus current is sampled twice in a present carrier cycle of the pulse width modulation; obtains a second sampling moment T1 when the direct current bus current is sampled at the second time in the present carrier cycle of the pulse width modulation, and a sampling value Idc1 obtained at the second sampling moment T1; obtains a second sampling moment T2 when the direct current bus current is sampled at the second time in a previous carrier cycle of the pulse width modulation before the present carrier cycle of the pulse width modulation, and a sampling value Idc2 obtained at the second sampling moment T2; and performs the phase difference compensation on the second sampling value Idc1 of the direct current bus current in the present carrier cycle of the pulse width modulation, where the compensation value = (Idc1 - Idc2) * $\Delta T/(T1- T2)$.

In the embodiment of the application, a phase shift of PWM is performed according to the calculated duty ratio of PWM and a preset minimum sampling time at first; a direct current bus current is sampled twice in a carrier cycle of PWM when a modulation vector is in an observable region, and a phase difference compensation is performed on the second sampling value of the direct current bus current, thus obtaining two phase currents of the motor according to the first sampling value of the direct current bus current and the compensated second sampling value of the direct current bus current; and a third phase current of the motor is calculated from the condition that the sum of the three-phase currents is equal to zero. The phase difference compensation is performed on the second sampling value of the direct current bus current, and thus an error brought by two different moments when the direct current bus current is sampled twice is reduced and an accuracy of the phase current reconstruction is improved.

Brief Description of the Drawings

Fig. 1 is a structural schematic diagram of an existing single current sampling inverter circuit;

Fig. 2 is a flow chart of a phase current reconstruction method according to an embodiment of the application;

Fig. 3 is a diagram of a space vector pulse width modulation;

Fig. 4 is a diagram of synthesizing a modulation vector by nonzero basic space vectors;

Fig. 5 is a diagram of a non-observable region during a space vector pulse width modulation;

Fig. 6 is a flow chart of a phase current reconstruction method according to another embodiment of the application;

Fig. 7 is a diagram of a non-observable region of a space vector pulse width modulation after a phase shift of the pulse width modulation;

Fig. 8 is a structural diagram of a phase current reconstruction apparatus according to an embodiment of the application; and

Fig. 9 is a structural diagram of a phase current reconstruction apparatus according to another embodiment of the application.

Detailed Description of the Embodiments

A phase current reconstruction method and a phase current reconstruction apparatus are provided according to embodiments of the application. For an easy understanding of the technical means implemented in the application, technical solutions in embodiments of the application are clearly and completely described below in combination with drawings. Apparently, the described embodiments are merely a few instead of all embodiments of the application. Based on the embodiments of the application, all other embodiments obtained by those skilled in the art without creative work are within the scope of the application.

First, a phase current reconstruction method provided in the embodiment of the application is described.

A phase current reconstruction method according to the embodiment of the application, which is applicable to a motor driven in a space vector pulse width modulation mode. The phase current reconstruction method includes:

calculating a duty ratio of a pulse width modulation according to a space voltage vector of the motor;

performing a phase shift on the pulse width modulation according to the obtained duty ratio of the pulse width modulation and a preset minimum sampling time;

sampling a direct current bus current twice in a carrier cycle of the pulse width modulation when a modulation vector is in an observable region, performing a phase difference compensation on the second sampling value of the direct current bus current, and obtaining two phase currents of the motor according to the first sampling value of the direct current bus current and the compensated second sampling value of the direct current bus current; and

calculating a third phase current of the motor according to the two phase currents of the motor.

In this way, according to the embodiment of the application, a phase shift of a PWM is performed according to the calculated duty ratio of PWM and a preset minimum sampling time at first; a direct current bus current is sampled twice in a carrier cycle of PWM when a modulation vector is in an observable region, and a phase difference compensation is performed on the second sampling value of the direct current bus current, thus obtaining two phase currents of the motor according to the first sampling value of the direct current bus current and the compensated second sampling value of the direct current bus current; and a third phase current of the motor is calculated from the condition that the sum of the three-phase currents is equal to zero. The phase difference compensation is performed on the second sampling value of the direct current bus current, and thus an error brought by two different moments when the direct current bus current is sampled twice is reduced.

Another phase current reconstruction method is provided according to an embodiment of the application, which is applicable to a motor driven in a space vector pulse width modulation mode. A flow of the method includes steps S101-S104, as shown in Fig. 2.

Step S101 includes: calculating a duty ratio of a pulse width modulation according to a space voltage vector.

It is noted that the space voltage vector is obtained with a control algorithm of a motor, and the control algorithm of the motor is obtained mainly based on a control mode of the motor. In the embodiment of the application, the control mode of space vector pulse width modulation is adopted by the motor, thus a space voltage vector of the motor can be obtained, and an angle and an amplitude of the space voltage vector can be obtained based on the space voltage vector.

Therefore, a duty ratio of the pulse width modulation can be calculated based on the angle and the amplitude of the space voltage vector.

Step S102 includes: performing a phase shift on the pulse width modulation according to the obtained duty ratio of the pulse width modulation and a preset minimum sampling time.

The phase shift on the pulse width modulation includes: shifting a pulse width modulation wave forwards or afterwards, to perform a vector decomposition and a vector compensation and increase an operation period of a nonzero basic space vector whose operation period is less than a minimum sampling time. In this way, an effective sampling of the current may be implemented.

Step S103 includes: sampling a direct current bus current twice in a carrier cycle of the pulse width modulation when a modulation vector is in an observable region, performing a phase difference compensation on the second sampling value of the direct current bus current, and obtaining two phase currents of the motor according to the first sampling value of the direct current bus current and the compensated second sampling value.

The modulation vector is synthesized by nonzero basic space vectors of a voltage vector pulse width modulation, and the nonzero basic space vectors are determined by states of switches in an inverter. In a carrier cycle of the pulse width modulation, when two nonzero basic space vectors operate, corresponding direct current bus currents are detected respectively. In combination with the corresponding relationship in table 1, two phase currents of the motor may be obtained. However, the two sampling values of the direct current bus current are not obtained at a same moment, thus a third phase current can not be obtained according to the condition that the sum of three-phase currents is equal to zero. Therefore, in the embodiment of the application, a phase difference compensation is performed on the second sampling value of the DC bus current, and thus an error brought by a phase difference between two samples is reduced. In particular, a phase difference compensation may include:

calculating a sample time difference $\Delta T$ between two sampling moments when the direct current bus current is sampled twice in a present carrier cycle of the pulse width modulation; and

obtaining a second sampling moment T1 when the direct current bus current is sampled at the second time in the present carrier cycle of the pulse width modulation, and a sampling value Idc1 obtained at the second sampling moment T1; obtaining a second sample moment T2 when the direct current bus current is sampled at the second time in a previous carrier cycle of the pulse width modulation before the present carrier cycle of the pulse width modulation, and a sampling value Idc2 obtained at the second sampling moment T2; and performing the phase difference compensation on the second sampling value Idc1 of the direct current bus current in the present carrier cycle of the pulse width modulation, where the compensation value = (Idc1 - Idc2) * $\Delta T$/(T1 - T2).

Step S104 includes: calculating a third phase current of the motor according to the obtained two phase currents of the motor.

Because a sum of three-phase currents is equal to zero, a third phase current of the motor can be calculated from the two phase currents of the motor.

In this way, in the embodiment of the application, a phase shift is performed on a pulse width modulation carrier wave, to increase the operation period of nonzero basic space vectors and reduce the area of the non-observable region, thus improving a success rate of the phase current reconstruction of a motor by detecting the direct current bus current. Furthermore, in the embodiment of the application, a phase difference compensation is performed on the second sampling value of the direct current bus current after two sampling values of the direct current bus current are obtained in a carrier cycle of the pulse width modulation, and thereby an error brought by phase difference between two samples is reduced, and an accuracy of the phase current reconstruction by the direct current bus current is improved.

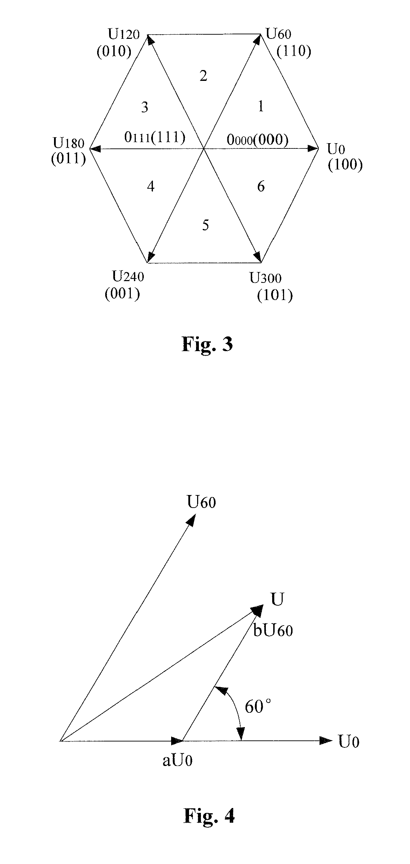

The Space Vector Pulse Width Modulation (SVPWM) adopted on the motor according to the embodiment of the application is highlighted below. As shown in Fig. 3, during SVPWM, a modulation space is divided into 6 sectors and 6 nonzero basic space vectors, as well as 2 zero vectors. Thus, the modulation vector is always in one of the sectors, which is synthesized by two basic space vectors adjacent to the sector. Fig. 4 shows a diagram of a modulation vector U in sector 1, which is synthesized by nonzero basic space vectors U0 and U60. The operation periods of the nonzero basic space vectors U0 and U60 are a and b, respectively. Therefore, the present modulation vector may be expressed as U=aU0+bU60. According to a requirement of space control, a modulation vector should follow a space voltage vector, and the space voltage vector is obtained according to a voltage-frequency curve and an operating frequency of the motor, or according to a control mode of the motor. Each basic space vector corresponds to a switching state of an inverter module, which is achieved by changing the states of 6 switch tubes. The operation period of the basic space vector is controlled by controlling the duration of the on states of the switch tubes. The modulation vector with any arbitrary direction and any magnitude can be synthesized by the operation periods of adjacent two basic space vectors, to drive the motor.

In a single current sampling method, to effectively reconstruct a phase current with a bus direct current sampling value, a sampling duration of the bus direct current should be longer than a minimum sampling time $T_{min}$, where $T_{min}$ is a sum of a dead time of PWM, a setup time of a current, and a hold time of MCU sampling. When a motor is driven in an SVPWM mode, it will occur that operation periods of one or two nonzero basic space vectors in a carrier cycle of PWM are too short to satisfy the minimum sampling time $T_{min}$ (i.e., a half of the operation period of the nonzero basic space vector is smaller than the minimum sampling time $T_{min}$) in the case that the SVPWM switches at a sector boundary or applies on a low-speed control, a region in which the operation period of any nonzero basic space vector in the carrier cycle of PWM is too short to satisfy the minimum sampling time $T_{min}$ such that a phase current can not be effectively reconstructed is called a non-observable region. Oppositely, a region in which the operation periods of both nonzero basic space vectors in the carrier cycle of PWM is larger than the minimum sampling time $T_{min}$ is called an observable region.

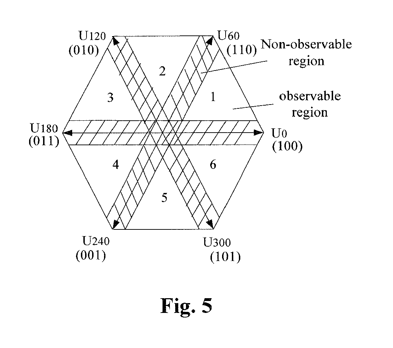

Referring to Fig. 5, when a motor is driven in the SVPWM mode and the SVPWM operates a switch at a sector boundary (hatched portions of Fig. 5), for example, when the SVPWM operates a switch at a region in the section 1 and close to a space vector V1, an operation period of a basic space vector V2 in a carrier cycle of PWM is too short, such that the operation period of the basic space vector V2 in the carrier cycle of PWM can not satisfy the minimum sampling time (i.e., a half of the operation period of the basic space vector V2 in the carrier cycle of PWM is smaller than the minimum sampling time). In this case, the sampling of the direct current bus current can not be accomplished. Similarly, when a switch is operated at a region in section 1 and close to the basic space vector V2, an operation period of a basic space vector V1 in a carrier cycle of PWM is too short to satisfy the sampling of the direct current bus current. For boundary areas of other sectors, there is always a nonzero basic space vector whose the operation period in a carrier cycle of PWM can not satisfy the requirement, which will not be repeatedly analyzed herein.

In addition to the condition that the operation period of one basic space vector can not satisfy the sampling of the direct current bus current when a switch is operated at a sector boundary, in the case that the motor is under a low-speed control, in some regions, the operation periods of both two adjacent nonzero basic space vectors in a same sector can not satisfy the sampling of the direct current bus current. The above regions, in which the phase current of the motor can not be reconstructed with the sampled direct current bus current, are called non-observable regions. Implementation of the single current sampling is severely impeded by the non-observable regions.

At present, a main method for solving the problem of non-observable regions is PWM phase shift method. A basic idea of the method includes: shifting a PWM wave to resolve and compensate the vector and increase the operation period of the nonzero basic space vector, so as to achieve an effective detection of the direct current bus current. A compensated nonzero basic space vector is generated after PWM phase shift, and the compensated vector is obtained by resolving a zero vector. Therefore, a key factor of the PWM phase shift technology is a minimum sampling time Tmin and an operation period T0 of the zero vector, where Tmin is determined by a difference between an actual characteristic of a device and an ideal characteristic of the device. For a certain system, Tmin is determined. In a condition that Tmin$\leqq$T0/4 is satisfied, the problem of non-observable regions can be effectively solved just by this method. However, in a high modulation region, an operation period of a zero vector decreases as a modulation ratio increases, and thus the application of the method in a high modulation region is limited. The problem of non-observable regions can not be solved by the PWM phase shift method, when the operation period of the zero vector is very short.

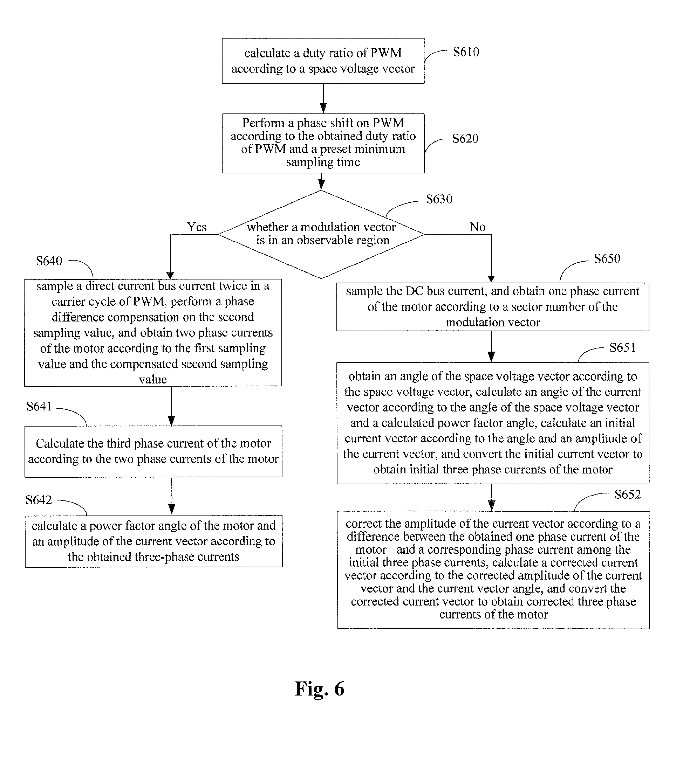

A method, by which a single current sampling can be achieved also in a non-observable region and a phase current reconstruction can be accomplished, is further provided in the embodiment. The method is applicable to a motor driven in an SVPWM mode. As shown in Fig. 6, the method includes steps S610, S620, S630, S640, S641, S642, S650, S651, and S652.

Step S610 includes: calculating a duty ratio of PWM according to a space voltage vector.

The above space voltage vector is determined by the control mode of the motor. When the control mode of the motor is determined, the space voltage vector can be obtained, and thus an angle and an amplitude of the space voltage vector can be obtained. Then, the duty ratio of PWM can be calculated according to the angle and the amplitude of the space voltage vector.

Step S620 includes: performing a phase shift on PWM according to the obtained duty ratio of PWM and a preset minimum sampling time.

It is noted that the above minimum sampling time is a sum of a dead time of PWM, a setup time of a current, and a hold time of MCU sampling. The minimum sampling time is determined when the system is determined.

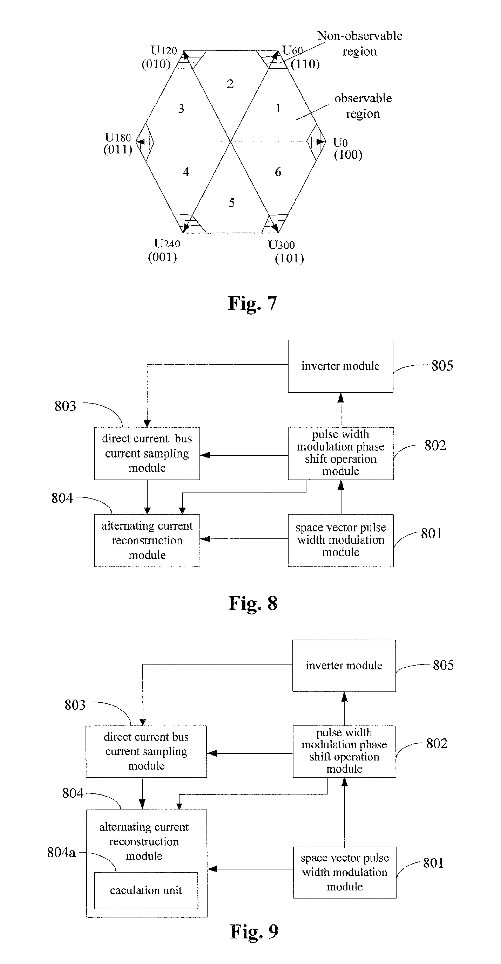

It is noted that the step of performing the phase shift of PWM according to the obtained duty ratio of PWM and a preset minimum sampling time essentially is to increase the operation period of the nonzero basic space vector. The increased amount of the operation period is provided by a zero vector. Thus, the operation period of the zero vector decreases as a modulation ratio increases. Therefore, an application of the method in a high modulation region is limited. After the phase shift of PWM, non-observable regions, where a phase current of the motor can not be effectively reconstructed, still exist, as shown in Fig. 7.

Step S630 includes: determining whether a modulation vector is in an observable region, performing step S640 if the modulation vector is in an observable region, and performing step S650 if the modulation vector is not in an observable region, i.e., the modulation vector is in a non-observable region.

Step S640 includes: sampling a direct current bus current twice in a carrier cycle of PWM, performing a phase difference compensation on the second sampling value of the direct current bus current, and obtaining two phase currents of the motor according to the first sampling value of the direct current bus current and the compensated second sampling value of the direct current bus current.

Step S641 includes: calculating the third phase current of the motor according to the two phase currents of the motor.

Step S642 includes: calculating a power factor angle of the motor and an amplitude of the current vector according to the obtained three-phase currents of the motor.

In a d-q rotating coordinate system, a d-axis direction may be defined as a direction of the space voltage vector. The three-phase current is resolved in the d-q rotating coordinate system into a component Id on the d-axis and a component Iq on the q-axis, where Id is an active component and Iq is a reactive component. Higher harmonics of the active components and the reactive components of the three-phase currents are filtered out by a low pass filter, and then the power factor angle is calculated according to the active components and the reactive components of the three-phase current.

A 3 phase to 2 phase coordinate transformation is performed on the obtained 3-phase current to obtain a current $I_\alpha$ along $\alpha$-axis and a current $I_\beta$ along $\beta$-axis in a two phase static coordinate system. Thus, the amplitude of the current vector may be expressed as $I_s = \sqrt{I_\alpha{}^2 + I_\beta{}^2}$ .

Step S650 includes: sampling the direct current bus current, and obtaining one phase current of the motor according to a sector number of the modulation vector and the sampling of the direct current bus current.

After the phase shift is performed on PWM, in the case that the modulation vector is in a non-observable region, an operation period of one of two nonzero basic space vectors for synthesizing the modulation vector is too short to satisfy requirement of a minimum sampling time, i.e., the direct current bus current can not be effectively sampled during the sampling of the nonzero basic space vector. However, an operation period of another one of the two nonzero basic space vectors for synthesizing the modulation vector satisfies requirement of the minimum sampling time. Therefore, in this case, the direct current bus current can be sampled by the nonzero basic space vector, whose operation period satisfies the requirement of the minimum sampling time and which is one of the nonzero basic space vectors for synthesizing the modulation vector. Thus, one phase current among three-phase currents is obtained.

Step S651 includes: obtaining an angle of the space voltage vector according to the space voltage vector, calculating an angle of the current vector according to the angle of the space voltage vector and a calculated power factor angle, calculating an initial current vector according to the angle of the current vector and a calculated amplitude of the current vector, and converting the initial current vector to obtain initial three-phase currents of the motor.

The power factor angle and the amplitude of the current vector are calculated according to the three-phase currents obtained by the modulation vector in a last observable region.

The power factor angle is an angle between the space voltage vector and the current vector. Therefore, the angle of the current vector can be calculated once the power factor angle and the angle of the space voltage vector are obtained. Then, the current vector can be obtained according to the angle and the amplitude of the current vector. The three-phase currents of the motor, i.e. the above initial three-phase currents can be obtained by converting the current vector.

Step S652 includes: correcting the amplitude of the current vector according to a difference between the one phase current of the motor obtained when the modulation vector is in the non-observable region and a corresponding phase current among the initial three-phase currents, calculating a corrected current vector according to the corrected amplitude of the current vector and the current vector angle, and converting the corrected current vector to obtain corrected three-phase currents of the motor.

One phase current among three-phase currents of the motor can be obtained accurately when the modulation vector is in a non-observable region. Therefore, a difference between the one phase current and a corresponding phase current among the initial phase currents can be calculated, and then the amplitude of the current vector may be corrected by the different. A new corrected current vector can be calculated according to the corrected amplitude and the angle of the current vector, and the new corrected current vector is converted to obtain corrected three-phase currents of the motor. Thus, the three-phase currents of the motor are effectively reconstructed in the non-observable region by sampling the direct current bus current.

In this way, the motor is driven in an SVPWM mode according to the embodiment of the application, and the phase shift of PWM is performed. When the modulation vector is in an observable region, a phase difference compensation is performed on the second sampling value in a carrier cycle of PWM, to obtain accurate three-phase currents of the motor. Then, a power factor angle and an amplitude of the current vector are calculated according to three-phase currents. When the modulation vector is in the non-observable region, initial 3 phase currents of the motor are calculated according to the angle of the space voltage vector, the power factor angle and the amplitude of the current vector, and the obtained initial three-phase currents are corrected according to one phase current detected in a non-observable region. In this way, a problem that an application of a single current method to a high modulation region is limited may be solved, a performance of single current sampling may be improved, and the single current method may be applied to a speed regulation system of an AC motor better. In addition, a method of phase difference compensation of a sampling point is adopted in the embodiment, and thus a problem of an error brought by a phase difference between sampling points is solved, and an accuracy of the phase current reconstruction is improved.

A phase current reconstruction apparatus, which may establish a communication connection with a motor driven in an SVPWM mode, is further provided according to an embodiment of the application. The phase current reconstruction apparatus includes:

a space vector pulse width modulation module, a pulse width modulation phase shift operation module, a direct current bus current sampling module, an alternating current reconstruction module and an inverter module.

The space vector pulse width modulation module is configured to calculate a duty ratio of a pulse width modulation according to a space voltage vector of the motor, and transmit the duty ratio of the pulse width modulation to the pulse width modulation phase shift operation module.

The pulse width modulation phase shift operation module is configured to perform a phase shift on the pulse width modulation according to the obtained duty ratio of the pulse width modulation and a preset minimum sampling time, generate a first control signal to control switches of the inverter module to be on or off and generate a second control signal to control the direct current bus current sampling module to sample the direct current bus current, and transmit a first reconstruction signal to the alternating current reconstruction module when a modulation vector is in an observable region.

The inverter module is configured to switch on or off the switches according to the received first control signal, to convert a bus direct current voltage into an alternating current voltage to drive the motor.

The direct current bus current sampling module is configured to sample the direct current bus current according to the received second control signal, and transmit a sampling value of the direct current bus current to the alternating current reconstruction module.

The alternating current reconstruction module is configured to receive two sampling values of the direct current bus current from the direct current bus current sampling module in a carrier cycle of the pulse width modulation, when the first reconstruction signal is received; perform a phase difference compensation on the second sampling value of the direct current bus current; and obtain two phase currents of the motor according to the first sampling value of the direct current bus current and the compensated second sampling value of the direct current bus current; and calculate a third phase current of the motor according to the obtained two phase currents of the motor.

In this way, in the phase current reconstruction apparatus according to the embodiment of the application, the space vector pulse width modulation module drives the motor in the space vector pulse width modulation mode and generates the duty ratio of the pulse width modulation. The pulse width modulation phase shift operation module performs the phase shift on the pulse width modulation according to the calculated duty ratio and a preset minimum sampling time. The alternating current reconstruction module obtains two sampling values of the direct current bus current from the direct current bus current sampling module when a modulation vector is in an observable region, and performs the phase difference compensation on the second sampling value in the carrier cycle. In this way, an error brought by two different sampling moments in the carrier cycle of the pulse width modulation is reduced, and an accuracy of the phase current reconstruction is improved.

Another phase current reconstruction apparatus is provided according to an embodiment of the application, which may be applicable to a motor driven in a space vector pulse width modulation mode. As shown in Fig. 8, the phase current reconstruction apparatus may includes:

a space vector pulse width modulation module 801, a pulse width modulation phase shift operation module 802, a direct current bus current sampling module 803, an alternating current reconstruction module 804 and an inverter module 805.

The space vector pulse width modulation module 801 is configured to calculate a duty ratio of a pulse width modulation according to a space voltage vector of the motor, and transmit the duty ratio of the pulse width modulation to the pulse width modulation phase shift operation module 802.

The space voltage vector is obtained with a control algorithm of the space vector pulse width modulation module 801. The space voltage vector is determined once the control mode of the space vector pulse width modulation module 801 is determined. An angle and an amplitude of the space voltage vector can be obtained from the space voltage vector, and then the duty ratio of PWM can be calculated based on the angle and the amplitude of the space voltage vector.

The pulse width modulation phase shift operation module 802 is configured to perform a phase shift on the pulse width modulation according to the obtained duty ratio and a preset minimum sampling time, generate a first control signal to control switches of the inverter module 805 to be on or off and generate a second control signal to control the direct current bus current sampling module 803 to sample the direct current bus current, and transmit a first reconstruction signal to the alternating current reconstruction module 804 when the modulation vector is in an observable region.

The minimum sampling time is a sum of a dead time of PWM, a setup time of a current, and a hold time of MCU sampling. The minimum sampling time is determined once the system is determined.

The pulse width modulation phase shift operation module 802 shifts a pulse width modulation wave forwards or backwards, to resolve and compensate the space vector, increase an operation period of a nonzero basic space vector having the operation period smaller than the minimum sampling time, so as to achieve an effective detection of the direct current bus current.

The inverter module 805 is configured to switch on or off the switches according to the received first control signal, and convert a bus direct current voltage into an alternating voltage to drive the motor.

The inverter module 805 may be an inverter.

The direct current bus current sampling module 803 is configured to sample the direct current bus current according to the received second control signal, and transmit a sampling value of the direct current bus current to the alternating current reconstruction module 804.

The direct current bus current sampling module 803 samples the direct current bus current twice in each carrier cycle of the pulse width modulation.

The alternating current reconstruction module 804 is configured to receive two sampling values of the direct current bus current from the direct current bus current sampling module 803 in a carrier cycle of the pulse width modulation, when the first reconstruction signal is received; perform a phase difference compensation on the second sampling value of the direct current bus current; obtain two phase currents of the motor according to the first sampling value of the direct current bus current and the compensated second sampling value of the direct current bus current; and calculate a third phase current of the motor according to the obtained two phase currents of the motor.

In one carrier cycle of the pulse width modulation, when two nonzero basic space vectors operate, corresponding direct current bus currents are detected respectively by the direct current bus current sampling module 803. In combination with the corresponding relationship in table 1, two phase currents of the motor may be obtained. However, the two sampling values of the direct current bus current are not obtained at a same moment by the direct current bus current sampling module 803, thus a third phase current can not be obtained according to the relation that a sum of the three-phase currents is equal to zero. Therefore, the alternating current reconstruction module 804 performs a phase difference compensation on the direct current bus current, and thus an error brought by a phase difference between two samples is reduced. In particular, the method may include the following steps.

calculating a sampling time difference $\Delta T$ between two sampling moments when the direct current bus current is sampled in a present carrier cycle of the pulse width modulation; and

obtaining a second sampling moment T1 when the direct current bus current is sampled at the second time in the present carrier cycle of the pulse width modulation, and a sampling value Idc1 obtained at the second sampling moment T1; obtaining a second sampling moment T2 when the direct current bus current is sampled at the second time in a previous carrier cycle of the pulse width modulation before the present carrier cycle of the pulse width modulation, and a sampling value Idc2 obtained at the second sampling moment T2, and performing the phase difference compensation on the second sampling value Idc1 of the direct current bus current in the present carrier cycle of the pulse width modulation, where the compensation value = (Idc1 - Idc2) * $\Delta T$/(T1-T2).

In this way, in the embodiment of the application, the pulse width modulation phase shift treatment module 802 performs a phase shift on a carrier wave of the pulse width modulation according to the duty ratio of PWM and the preset minimum sampling time, and thus increasing an operation period of a nonzero basic space vector; reducing an area of non-observable region, and improving a success rate of the phase current reconstruction of a motor by detecting a direct current bus current. Furthermore, the alternating current reconstruction module 804 performs the phase difference compensation on the second sampling value in a carrier cycle of the pulse width modulation, thus an error brought by a phase difference between two sampling is reduced, and an accuracy of the phase current reconstruction by the DC bus current is improved.

Another phase current reconstruction apparatus is provided according to an embodiment of the application, which establishes a communication connection with a motor driven in an SVPWM mode. As shown in Fig. 9, the phase current reconstruction apparatus includes:

an space vector pulse width modulation module 801, a pulse width modulation phase shift operation module 802, a direct current bus current sampling module 803, an alternating current reconstruction module 804 and an inverter module 805, where the alternating current reconstruction module 804 further includes a calculation unit 804a.

The space vector pulse width modulation module 801 is configured to calculate a duty ratio of a pulse width modulation according to a space voltage vector of the motor, and transmit the duty ratio of the pulse width modulation to the pulse width modulation phase shift operation module 802.

The space vector pulse width modulation module 801 is further configured to detect a sector number of the modulation vector, and transmit the sector number to the alternating current reconstruction module 804.

The pulse width modulation phase shift operation module 802 is configured to perform a phase shift on the pulse width modulation according to the obtained duty ratio and a preset minimum sampling time, generate a first control signal to control switches of the inverter module 805 to be on or off and generate a second control signal to control the direct current bus current sampling module 803 to sample the direct current bus current, transmit a first reconstruction signal to the alternating current reconstruction module 804 when a modulation vector is in an observable region, and transmit a second reconstruction signal to the alternating current reconstruction module 804 when the modulation vector is in a non-observable region.

The inverter module 805 is configured to switch on or off the switches according to the received first control signal, and to convert a bus direct current voltage into an alternating current voltage to drive the motor.

The direct current bus current sampling module 803 is configured to sample the direct current bus current according to the received second control signal, and transmit a sampling value of the direct current bus current to the alternating current reconstruction module 804.

It is noted that after the phase shift is performed on the pulse width modulation, when a modulation vector is in a non-observable region, because an operation period of one of two nonzero basic space vectors for synthesizing the modulation vector is too short to satisfy requirement of a minimum sampling time, the direct current bus current sampling module 803 can not effectively sample the direct current bus current with the one nonzero basic space vector. However, an operation period of another one of the two nonzero basic space vectors for synthesizing the modulation vector satisfies requirement of the minimum sampling time. Therefore, the direct current bus current sampling module 803 may sample the direct current bus current with this nonzero basic space vector. Thus, a phase current among three-phase currents of the motor is obtained.

The alternating current reconstruction module 804 is configured to receive two sampling values of the direct current bus current from the direct current bus current sampling module 803 in a carrier cycle of the pulse width modulation, when the first reconstruction signal is received; perform a phase difference compensation on the second sampling value of the direct current bus current; obtain two phase currents of the motor according to the first sampling value of the direct current bus current and the compensated second sampling value of the direct current bus current; and calculate a third phase current of the motor according to the obtained two phase currents of the motor.

The calculation unit 804a in the AC current reconstruction module 804 is configured to calculate a power factor angle of the motor and an amplitude of a current vector according to three-phase currents of the motor which is obtained by the alternating current reconstruction module 804 when the first reconstruction signal is received, and calculate an angle of a space voltage vector according to the space voltage vector.

It is noted that the calculation unit 804a calculate a power factor angle and an amplitude of the current vector according to the obtained three-phase currents by the following steps:

performing, by the calculation unit 804a, coordinate transformation based on an oriented space voltage vector of the motor on the obtained three-phase currents of the motor, to obtain active components and reactive components of the three-phase currents;

filtering out higher harmonics of the active component and the reactive component; and

calculating the power factor angle of the motor and the amplitude of the current vector according to the active components and the reactive components of the three-phase currents after filtering out the higher harmonics.

The alternating current reconstruction module 804 is further configured to calculate an angle of a current vector according to the angle of the space voltage vector and the power factor angle both of which are calculated by the calculation unit 804a, calculate an initial current vector according to the angle and the amplitude of the current vector, and convert the initial current vector to obtain initial three-phase currents of the motor, when the second reconstruction signal is received.

The alternating current reconstruction module 804 is further configured to obtain one phase current of the motor from the direct current bus current sampling module 803 according to the received sector number, when the second reconstruction signal is received; correct the amplitude of the current vector according to a difference between the one phase current and a corresponding phase current among the initial three-phase currents of the motor; calculate a corrected current vector according to the corrected amplitude of the current vector and the angle of the current vector, and convert the corrected current vector to obtain corrected three-phase currents of the motor. In this way, the three-phase currents of the motor may be effectively reconstructed in a non-observable region by sampling the direct current bus current.

In this way, in the embodiment of the application, the motor is driven in a space voltage vector provided by the the space vector pulse width modulation module 801, and the pulse width modulation phase shift operation module performs the phase shift on the pulse width modulation according to a preset minimum sampling time and a duty ratio. The alternating current reconstruction module 804 performs the phase difference compensation on the second sampling value in the carrier cycle of the pulse width modulation, to obtain accurate three-phase currents. The calculation unit of the alternating current reconstruction module 804 calculates a power factor angle of the motor and an amplitude of the current vector according to the three-phase currents. The alternating current reconstruction module 804 obtains initial 3 phase currents of the motor according to the angle of space voltage vector, the power factor angle and the amplitude of the current vector, when the modulation vector is in a non-observable region; and corrects the obtained initial three-phase currents according to a phase current detected in the non-observable region. Therefore, a problem that a single current sampling method applied to a high modulation region is limited is solved; a performance of single current sampling is improved; and the single current method can be applied to a speed regulation system better. In addition, in the embodiment of the application, a sampling point phase difference compensation method is adopted by the alternating current reconstruction module, a problem of an error brought by a phase difference between sampling points is resolved, and an accuracy of the phase current reconstruction by the DC bus current is improved.

The phase current reconstruction method and the phase current reconstruction apparatus provided in the embodiments of the application are introduced above in detail. Particular examples are used to describe the principles and the embodiments in the application. The description of the above embodiments is merely to help understanding the method in the application and the core idea thereof. In addition, for those skilled in the art, there are modifications in particular embodiments or applications according to the idea of the application. In summary, the description should not be construed as limitation to the application.

## Claims

1. A phase current reconstruction method, applicable to a motor driven in a space vector pulse width modulation mode, comprising:

   calculating a duty ratio of a pulse width modulation according to a space voltage vector of the motor;
   performing a phase shift on the pulse width modulation according to the obtained duty ratio of the pulse width modulation and a preset minimum sampling time;
   sampling a direct current bus current twice in a carrier cycle of the pulse width modulation when a modulation vector is in an observable region, performing a phase difference compensation on the second sampling value of the direct current bus current, and obtaining two phase currents of the motor according to the first sampling value of the direct current bus current and the compensated second sampling value of the direct current bus current; and
   calculating a third phase current of the motor according to the two phase currents of the motor.

2. The phase current reconstruction method according to claim 1, wherein the calculating a duty ratio of a pulse width modulation according to a space voltage vector of the motor comprises:

   calculating an angle and an amplitude of the space voltage vector according to the space voltage vector of the motor; and
   calculating the duty ratio of the pulse width modulation according to the obtained angle and amplitude of the space voltage vector.

3. The phase current reconstruction method according to claim 2, further comprising:

   calculating a power factor angle of the motor and an amplitude of a current vector, according to three-phase currents of the motor obtained when the modulation vector is in the observable region;
   obtaining one phase current of the motor according to a sector number of the modulation vector and the sampling of the direct current bus current, when the modulation vector is in a non-observable region;
   calculating an angle of a current vector according to the angle of the space voltage vector and the power factor angle, calculating the current vector according to the obtained angle of the current vector and the amplitude of the current vector, and converting the current vector to obtain initial three-phase currents of the motor; and
   correcting the amplitude of the current vector according to a difference between the one phase current of the motor obtained when the modulation vector is in the non-observable region and a corresponding phase current among the initial three-phase currents, calculating a corrected current vector according to the corrected amplitude of the current vector and the angle of the current vector, and converting the corrected current vector to obtain corrected three-phase currents of the motor.

4. The phase current reconstruction method according to claim 3, wherein the calculating a power factor angle of the motor and an amplitude of a current vector according to three-phase currents of the motor obtained when the modulation vector is in the observable region comprises:

performing coordinate transformation based on an oriented space voltage vector of the motor on the obtained three-phase currents of the motor, to obtain active components and reactive components of the three-phase currents;
filtering out higher harmonics of the active components and the reactive components; and
calculating the power factor angle of the motor and the amplitude of the current vector according to the active components and the reactive components of the three-phase currents after filtering out the higher harmonics.

5. The phase current reconstruction method according to claim 1, wherein the sampling a direct current bus current twice in a carrier cycle of the pulse width modulation and performing a phase difference compensation on the second sampling value of the direct current bus current comprises:

calculating a sampling time difference $\Delta T$ between two sampling moments when the direct current bus current is sampled twice in a present carrier cycle of the pulse width modulation; and
obtaining a second sampling moment T1 when the direct current bus current is sampled at the second time in the present carrier cycle of the pulse width modulation and a sampling value Idc1 obtained at the second sampling moment T1; obtaining a second sampling moment T2 when the direct current bus current is sampled at the second time in a previous carrier cycle of the pulse width modulation before the present carrier cycle of the pulse width modulation, and a sampling value Idc2 obtained at the second sampling moment T2; and performing the phase difference compensation on the second sampling value Idc1 of the direct current bus current in the present carrier cycle of the pulse width modulation, wherein a compensation value = (Idc1 - Idc2) * $\Delta T/(T1-T2)$.

6. A phase current reconstruction apparatus, which establishes a communication connection with a motor driven in a space vector pulse width modulation mode, wherein the phase current reconstruction apparatus comprises a space vector pulse width modulation module, a pulse width modulation phase shift operation module, a direct current bus current sampling module, an alternating current reconstruction module and an inverter module; and wherein

the space vector pulse width modulation module is configured to calculate a duty ratio of a pulse width modulation according to a space voltage vector of the motor, and transmit the duty ratio of the pulse width modulation to the pulse width modulation phase shift operation module;
the pulse width modulation phase shift operation module is configured to perform a phase shift on the pulse width modulation according to the obtained duty ratio of the pulse width modulation and a preset minimum sampling time; generate a first control signal to control switches of the inverter module to be on or off and generate a second control signal to control the direct current bus current sampling module to sample the direct current bus current; and transmit a first reconstruction signal to the alternating current reconstruction module when a modulation vector is in an observable region;
the inverter module is configured to switch on or off the switches according to the received first control signal, and convert a bus direct current voltage into an alternating voltage to drive the motor;
the direct current bus current sampling module is configured to sample the direct current bus current according to the received second control signal, and transmit a sampling value of the direct current bus current to the alternating current reconstruction module; and
the alternating current reconstruction module is configured to receive two sampling values of the direct current bus current from the direct current bus current sampling module in a carrier cycle of the pulse width modulation, when the first reconstruction signal is received; perform a phase difference compensation on the second sampling value of the direct current bus current; obtain two phase currents of the motor according to the first sampling value of the direct current bus current and the compensated second sampling value of the direct current bus current; and calculate a third phase current of the motor according to the obtained two phase currents of the motor.

7. The phase current reconstruction apparatus according to claim 6, wherein the space voltage vector pulse width modulation module calculates an angle and an amplitude of the space voltage vector according to the space voltage vector of the motor, and calculates the duty ratio of the pulse width modulation according to the obtained angle and amplitude of the space voltage vector.

8. The phase current reconstruction apparatus according to claim 7, wherein the alternating current reconstruction module further comprises: a calculation unit configured to calculate a power factor angle of the motor and an amplitude of a current vector according to the three-phase currents of the motor obtained when the first reconstruction signal is received;

the space voltage vector pulse width modulation module is further configured to detect a sector number of the modulation vector, and transmit the sector number to the alternating current reconstruction module;

the pulse width modulation phase shift operation module is further configured to transmit a second reconstruction signal to the alternating current reconstruction module when the modulation vector is in a non-observable region;

the alternating current reconstruction module is further configured to calculate an angle of the current vector according to the angle of the space voltage vector and the power factor angle, calculate the current vector according to the angle and the amplitude of the current vector when the second reconstruction signal is received, and convert the current vector to obtain initial three-phase currents of the motor; and

the alternating current reconstruction module is further configured to obtain one phase current of the motor from the direct current bus current sampling module according to the received sector number, when the second reconstruction signal is received; correct the amplitude of the current vector according to a difference between the one phase current of the motor and a corresponding phase current among the initial three-phase currents, calculate a corrected current vector according to the corrected amplitude of the current vector and the angle of the current vector, and convert the corrected current vector to obtain corrected 3-phase currents of the motor.

9. The phase current reconstruction apparatus according to claim 8, wherein the calculation unit performs coordinate transformation based on an oriented space voltage vector of the motor on the obtained three-phase currents of the motor, to obtain active components and reactive components of the three-phase currents; filters out higher harmonics of the active components and the reactive components; and calculates the power factor angle of the motor and the amplitude of the current vector according to the active components and the reactive components of the 3-phase currents after filtering out the higher harmonics.

10. The phase current reconstruction apparatus according to claim 6, wherein the alternating current reconstruction module calculates a sampling time difference $\Delta T$ between two sampling moments when the direct current bus current is sampled twice in a present carrier cycle of the pulse width modulation; obtains a second sampling moment T1 when the direct current bus current is sampled at the second time in the present carrier cycle of the pulse width modulation, and a sampling value Idc1 obtained at the second sampling moment T1; obtains a second sampling moment T2 when the direct current bus current is sampled at the second time in a previous carrier cycle of the pulse width modulation before the present carrier cycle of the pulse width modulation, and a sampling value Idc2 obtained at the second sampling moment T2; and performs the phase difference compensation on the second sampling value Idc1 of the direct current bus current in the present carrier cycle of the pulse width modulation, wherein a compensation value = (Idc1 - Idc2) * $\Delta T$/(T1- T2).

**Fig. 1**

**Fig. 2**

**Fig. 3**

**Fig. 4**

Fig. 5

```
┌─────────────────────────────────┐
│  calculate a duty ratio of PWM  │╱─ S610
│  according to a space voltage   │
│            vector               │
└─────────────────────────────────┘
                 │
                 ▼
┌─────────────────────────────────┐
│   Perform a phase shift on PWM  │
│  according to the obtained duty │╱─ S620
│  ratio of PWM and a preset      │
│  minimum sampling time          │
└─────────────────────────────────┘
                 │
                 ▼
         ╱────── S630
   ╱◇◇◇◇◇◇◇◇◇◇◇◇◇◇◇◇◇◇◇◇◇◇◇◇◇╲
Yes  whether a modulation vector     No
   ╲    is in an observable region  ╱
     ╲◇◇◇◇◇◇◇◇◇◇◇◇◇◇◇◇◇◇◇◇◇◇◇◇◇╱
```

S640

sample a direct current bus current twice in a carrier cycle of PWM, perform a phase difference compensation on the second sampling value, and obtain two phase currents of the motor according to the first sampling value and the compensated second sampling value

S641

Calculate the third phase current of the motor according to the two phase currents of the motor

S642

calculate a power factor angle of the motor and an amplitude of the current vector according to the obtained three-phase currents

S650

sample the DC bus current, and obtain one phase current of the motor according to a sector number of the modulation vector

S651

obtain an angle of the space voltage vector according to the space voltage vector, calculate an angle of the current vector according to the angle of the space voltage vector and a calculated power factor angle, calculate an initial current vector according to the angle and an amplitude of the current vector, and convert the initial current vector to obtain initial three phase currents of the motor

S652

correct the amplitude of the current vector according to a difference between the obtained one phase current of the motor and a corresponding phase current among the initial three phase currents, calculate a corrected current vector according to the corrected amplitude of the current vector and the current vector angle, and convert the corrected current vector to obtain corrected three phase currents of the motor

**Fig. 6**

**Fig. 7**

**Fig. 8**

**Fig. 9**

# INTERNATIONAL SEARCH REPORT

| International application No. |
|---|
| **PCT/CN2012/080149** |

## A. CLASSIFICATION OF SUBJECT MATTER

H02P 21/14 (2006.01) i

According to International Patent Classification (IPC) or to both national classification and IPC

## B. FIELDS SEARCHED

Minimum documentation searched (classification system followed by classification symbols)

IPC: H02P

Documentation searched other than minimum documentation to the extent that such documents are included in the fields searched

Electronic data base consulted during the international search (name of data base and, where practicable, search terms used)

CNPAT, WPI, EPODOC, CNKI: phase shift current reconstruct+ vector sampl+ PWM pulse w width w modulat+ compensat+ phase w current bus

## C. DOCUMENTS CONSIDERED TO BE RELEVANT

| Category* | Citation of document, with indication, where appropriate, of the relevant passages | Relevant to claim No. |
|---|---|---|
| A | CN 101674046 A (TSINGHUA UNIVERSITY), 17 March 2010 (17.03.2010), see description, page 6, line 6 to page 17, line 15, and figures 1-20 | 1-10 |
| A | CN 101769953 A (TECO GROUP SCIENCE-TECHNOLOGY (HANGZHOU) CO., LTD.), 07 July 2010 (07.07.2010), the whole document | 1-10 |
| A | US 6984953 B2 (INT RECTIFIER CORP.), 10 January 2006 (10.01.2006), the whole document | 1-10 |

☐ Further documents are listed in the continuation of Box C.     ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 11 April 2013 (11.04.2013) | **02 May 2013 (02.05.2013)** |

| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer **LI, Lu** Telephone No.: (86-10) **62411792** |
|---|---|

Form PCT/ISA/210 (second sheet) (July 2009)

## INTERNATIONAL SEARCH REPORT
### Information on patent family members

| | International application No. |
|---|---|
| | **PCT/CN2012/080149** |

| Patent Documents referred in the Report | Publication Date | Patent Family | Publication Date |
|---|---|---|---|
| CN 101674046 A | 17.03.2010 | CN 101674046 B | 14.09.2011 |
| CN 101769953 A | 07.07.2010 | None | |
| US 6984953 B2 | 10.01.2006 | US 2004195995 A1 | 07.10.2004 |

Form PCT/ISA/210 (patent family annex) (July 2009)